Europäisches Patentamt

European Patent Office

Office européen des brevets

(11) Publication number: **0 488 186 A1**

# EUROPEAN PATENT APPLICATION

(21) Application number: **91120207.5**

(22) Date of filing: **26.11.91**

(51) Int. Cl.5: **H01L 23/485**

(30) Priority: **29.11.90 JP 333073/90**

(43) Date of publication of application:
**03.06.92 Bulletin 92/23**

(84) Designated Contracting States:
**DE FR GB**

(71) Applicant: **Kabushiki Kaisha Toshiba
72, Horikawa-cho Saiwai-ku
Kawasaki-shi(JP)**

(72) Inventor: **Kunieda, Mitsuyuki, c/o Intellectual
Property Div.
Kabushiki Kaisha Toshiba, 1-1 Shibaura
1-chome
Minato-ku, Tokyo 105(JP)**
Inventor: **Tsuchiya, Ikuo, c/o Intellectual
Property Div.
Kabushiki Kaisha Toshiba, 1-1 Shibaura
1-chome
Minato-ku, Tokyo 105(JP)**
Inventor: **Maruyama, Junko, c/o Intellectual
Property Div.
Kabushiki Kaisha Toshiba, 1-1 Shibaura
1-chome
Minato-ku, Tokyo 105(JP)**

(74) Representative: **Lehn, Werner, Dipl.-Ing. et al
Hoffmann, Eitle & Partner Patentanwälte
Arabellastrasse 4
W-8000 München 81(DE)**

(54) **Shape of bonding pad of semiconductor device bonded by wire bonding method.**

(57) A semiconductor chip (100) is die-bonded to a bed (101) of a lead frame. Bonding pads (102) are formed on the semiconductor chip (100) along its periphery. The bonding pads (102) have at least one obtuse-angle corner portion of corner portions facing a nearest side of the chip (100). Each of the bonding pads (102) is bonded to an inner lead portion (106) of the lead frame by a bonding wire (104).

F I G. 1

The present invention relates to a semiconductor device in which a bonding pad is wired to an inner lead portion of a lead frame using a wire bonding method and, more particularly, to a shape of a bonding pad suitable for reducing bonding defects of an LSI having a large number of pins.

In recent years, as a degree of integration and the number of functions of an LSI are increased according to the development of an LSI manufacturing technique, the number of pins of an LSI is necessarily increased. In contrast to this, an active region in which the size of an active element is formed is not so large due to the development of a micropatterning processing technique. Therefore, when a conventional pattern layout rule is still employed, a waste portion is formed in the active region on a chip of the LSI because the number of bonding pads is increased, thereby increasing the chip size. For this reason, various problems such as a decrease in mounting density or an increase in manufacturing cost are posed.

In order to eliminate a waste portion in a active region and to increase the number of pins, a pitch between pads must be decreased, or pads must be arranged in even an active region. As a bonding technique coping with an increase in number of pins, a wireless bonding technique such as a flip-chip method or a tape carrier method has received a great deal of attention. However, in these methods, the shape of a chip, the position of a wire formed in the chip, the structure of bonding pads must be largely changed from those in a popular wire bonding method. In addition, these methods have no flexibility for a change in type of an LSI and a problem on radiation of heat generated during the operation of the LSI. For this reason, at present, these methods are employed to only specific types devices, and the wire bonding method is still employed in mass-production devices having a considerably large number of pins.

A wire bonding method is generally performed by the following procedure. A semiconductor chip (to be referred to as a chip hereinafter) on which a semiconductor element is formed is die-bonded on the bed of a lead frame. Bonding pads (to be referred to as only pads hereinafter) are formed on the chip along its outer periphery. Each of these pads generally has a square shape and is made of a material such as aluminum or the like. Each of the pads is bonded to the inner lead portion of the lead frame by a bonding wire (to be referred to as a wire).

In a semiconductor device using the above wire bonding method, the pitch between the pads is limited by the diameter and angle of the capillary of a bonding apparatus, the diameter of the wire, the height and angle of the loop of the wire, accuracy of the bonding position. For this reason, when the pitch between the pads is decreased or the incident angle of the wire (an angle between an imaginary line perpendicular to one side of a chip and the wire) is increased, a bonding defect may be formed. This bonding defect practically means that the tail of the wire is brought into contact with a pad adjacent to the pad connected to the wire, and that a dent formed between a pad and a wire during the bonding operation is brought into contact with a pad or wire adjacent to the dent.

In addition to the above defects, when a wire crosses the pad adjacent to the pad bonded to the wire when viewed from the upper direction, the chip is determined as a defective product in a visual check performed in manufacturing steps. Although this chip is a non-defective product, the chip in which the wire is not in contact with the adjacent pad is detected as a defected product, because it is highly possible that the wire crossing over the pad may be brought into contact with the pad in the later resin-sealing step or the like.

It is, therefore, the first object of the present invention to provide a semiconductor device including a bonding pad having a shape which does not easily form a bonding defect even when a pitch between pads is decreased or an incident angle of a wire is increased.

It is the second object of the present invention to provide a semiconductor device employing a wire bonding method capable of minimizing a possibility of contact between the tail of a wire and the pad adjacent to the pad bonded to this wire and a possibility of contact between a pad or wire and a dent formed between a pad and a wire during a bonding operation and adjacent to the pad or wire.

It is the third object of the present invention to provide a semiconductor device employing a wire bonding method capable of increasing an assembly yield.

In order to achieve the above objects, according to the present invention, there is provided a semiconductor device employing a wire bonding method, comprising a semiconductor chip on which at least one semiconductor element is formed, a bonding pad formed on the semiconductor chip and having a planar shape having at least one obtuse-angle corner portion facing the nearest side of the semiconductor chip, a bonding wire for connecting the bonding pad with an inner lead portion of a lead frame.

The pad of the semiconductor device has a shape obtained by performing so-called "chamfering" to the corner portion of a conventional square pad facing a nearest side of the semiconductor chip. Since a portion in which a wire is most easily brought into contact with a pad adjacent to the pad bonded to the wire is a corner portion in a square pad, when this corner portion is notched, bonding defects are not easily formed even when a pitch between pads is decreased or an incident angle of a wire is increased. That is, a possibility of contact between the tail of a wire and a pad adjacent to the pad bonded to the wire and a possibility of contact between a dent formed between a pad and a wire during a bonding operation and a pad or wire adjacent to the dent can be minimized. As a result, an assembly yield can be increased.

This invention can be more fully understood from the following detailed description when taken in conjunction with the accompanying drawings, in which:

Fig. 1 is a plan view for explaining a main part of a semiconductor device employing a wire bonding method according to the first embodiment of the present invention;

Fig. 2 is an enlarged view showing a part of Fig. 1;

Fig. 3 is a plan view for explaining a main part of a semiconductor device employing a wire bonding method according to the second embodiment of the present invention;

Fig. 4 is an enlarged view for explaining a main part of a semiconductor device employing a wire bonding method according to the third embodiment of the present invention;

Fig. 5 is an enlarged view for explaining a main part of a semiconductor device employing a wire bonding method according to the fourth embodiment of the present invention;

Fig. 6 is an enlarged perspective view for explaining a main part of a semiconductor device employing a wire bonding method according to the fifth embodiment of the present invention; and

Fig. 7 is an enlarged perspective view for explaining a main part of a semiconductor device employing a wire bonding method according to the sixth embodiment of the present invention.

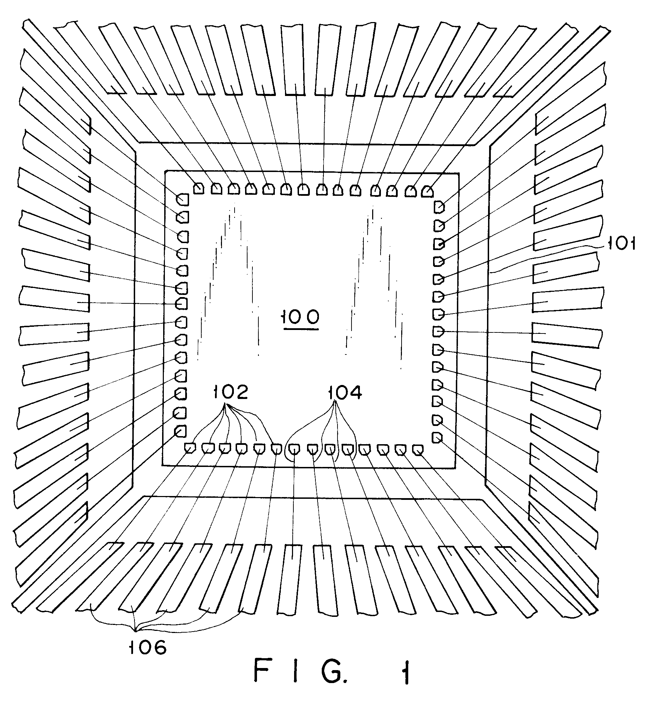

Fig. 1 is a plan view showing a semiconductor chip, an inner lead portion of a lead frame, bonding wires, and the like on a semiconductor device employing a wire bonding device according to the first embodiment of the present invention.

A semiconductor chip 100 is die-bonded to a bed portion 101 of a lead frame. At least one semiconductor element is formed on the chip 100, and bonding pads 102 are arranged along the outer periphery of the chip 100. Each of the pads 102 is made of aluminum or the like, and the two corner portions of each of the pads 102 facing an incident direction of bonding wires 104 (in other words, a side of the chip 100 which the bonding wires 104 cross) are cut to have obtuse angles. That is, each of the square pads 102 has a planar shape obtained by chamfering the two corners facing a side of the chip 100 to which the bonding wires 104 cross.

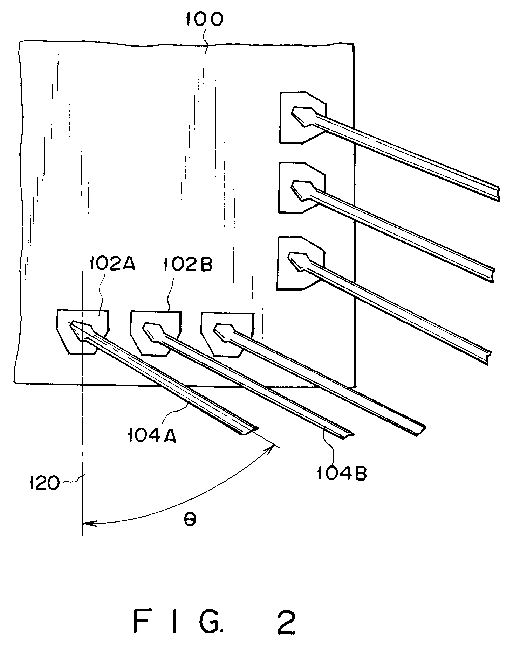

Fig. 2 is an enlarged view showing a part of Fig. 1.

As shown in Fig. 2, since each of the pads 102 has the two obtuse-angle corner portions facing a side of the chip 100 which the wires 104 cross, even when an incident angle $\theta$ of the wires 104 (an angle between an imaginary line 120 perpendicular to one side of the wire-crossing chip 100 and the wire) is increased, for example, a wire 104A dose not cross a pad 102B adjacent to a pad 102A bonded to the wire 104A. In addition, when the wire 104A is to be led to the pad 102A by a capillary (not shown), the wire 104A does not pass near the pad 102B. For these reasons, contact between the adjacent pad 102B and the tail of the wire 104A can be prevented, and contact between a dent formed between the pad 102A and the wire 104A during a bonding operation and the adjacent pad 102B or the adjacent wire 104B can be prevented. In addition, since the wire 104A does not easily cross the pad 102B when viewed from the above of the chip, the chip is not easily determined as a defective product in a visual check, and the wire 104A is not easily brought into contact with the pad 102B in a later resin-sealing step.

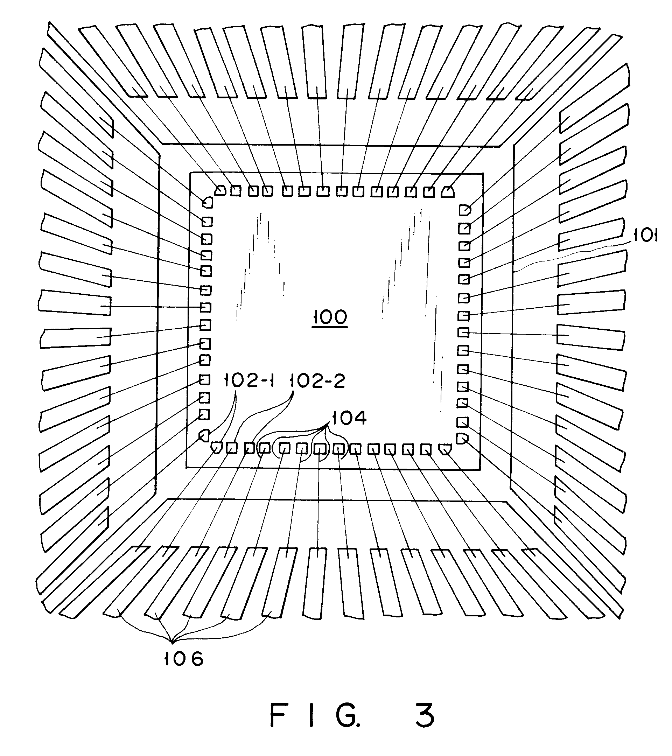

Fig. 3 is a plan view showing a semiconductor chip, the inner lead portion of a lead frame, bonding wires, and the like on a semiconductor device employing a wire bonding method according to the second embodiment of the present invention.

Chamfering is performed to all the pads 102 in the first embodiment. However, in the second embodiment, chamfering is performed to pads 102-1 arranged at the corner portions of a chip 100, and other pads 102-2 have square shapes.

Since an incident angle $\theta$ is especially increased at the corner portions of the chip, even when the pads each having the above chamfered shape are arranged at only the corner portions, the same effect as described in the first embodiment can be obtained. Since a pattern can be formed easier by pads having the same shape than by pads having different shapes, all the pads 102 are chamfered in the first embodiment. Therefore, even when only the pads 102-1 at the corner portions of the chip 100 have shapes different from those of other pads, a substantial difference between these effects cannot be found.

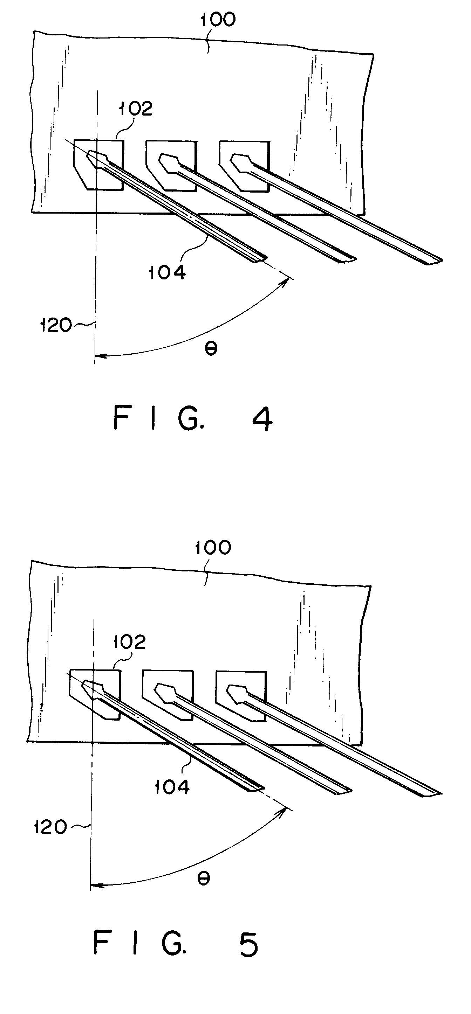

Fig. 4 is a view for explaining a semiconductor device employing a wire bonding method according to the third embodiment of the present invention and an enlarged view showing a main part of the semiconductor device. As shown in Fig. 4, chamfering is performed to the corner portions of pads 102 along only an incident direction of wires 104. In other words, although the pads 102 and 102-1 according to the first and second embodiments are hexagonal pads, the pads 102 according to the third embodiment are pentagonal pads. Since undesirable contact between a wire and a pad occurs in only one direction, even when the pads 102 have the shapes shown in Fig. 4, the effect of the third embodiment is substantially equal to that of the first embodiment.

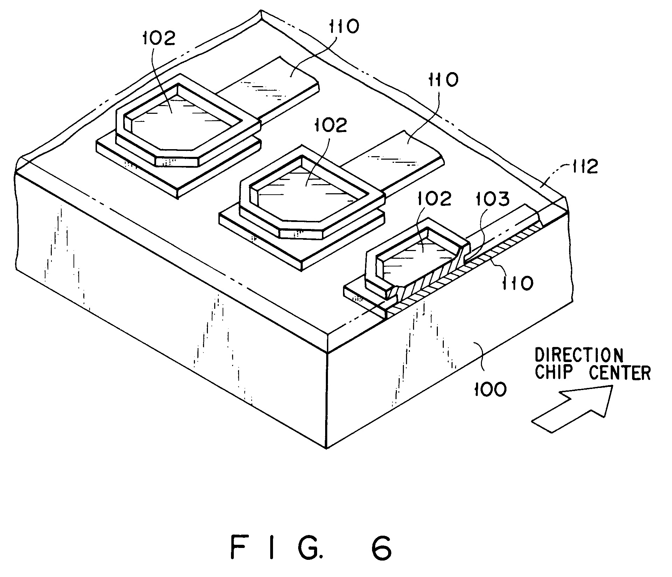

Most preferably, as shown in Fig. 5, a side obtained by chamfering the corner portion of each of the pads 102 is substantially parallel to a corresponding wire 104. However, since the individual pads 102 have different shapes, pattern design is complicated.

Fig. 6 is an enlarged and perspective view showing a main part of a semiconductor device employing a wire bonding method according to the fifth embodiment of the present invention.

According to the fifth embodiment, pads are formed by two or more aluminum layers. A first-level aluminum wiring layer 110 is formed to reach the outer periphery of a chip 100, its distal end portion (to be referred to a first-level bonding pad) is formed to have a shape similar to that of a normal shape. An insulating film 112 is formed on the wiring layer 110 and the chip 100. An opening portion 103 is formed in the insulating film 112 at a position corresponding to the first-level bonding pad. A pad 102 constituted by a second-level (or higher level) aluminum layer is formed on a part of the insulating layer 112 and in the opening portion 103. The corner portions of the second-level pad 102 facing one side of the chip 100 which a wire crosses are chamfered.

As described above, when a bonding pad is formed by using two (three or more) aluminum layers, the present invention can be employed.

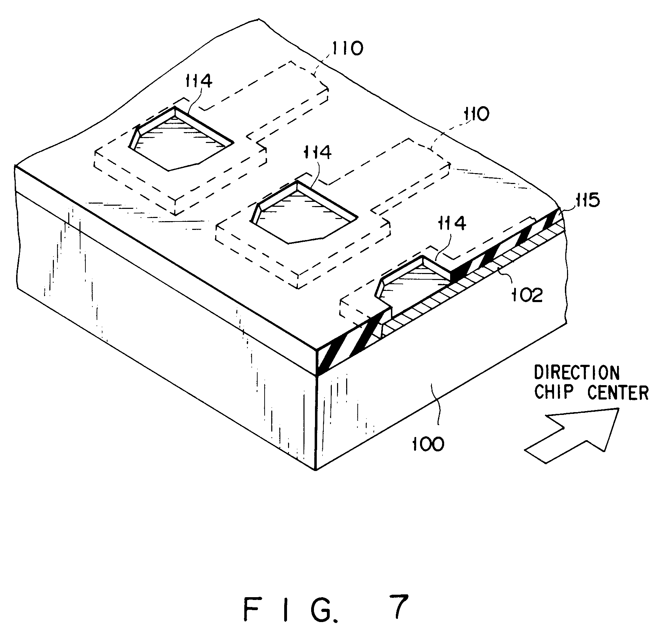

Fig. 7 is a enlarged and perspective view showing a main part of a semiconductor device employing a wire bonding method according to the sixth embodiment of the present invention.

According to this embodiment, the so-called "chamfered" shape of the pad 102 described in the above embodiments is not applied to the pad 102 itself but to an opening portion 114 of a protection film 115 on the pad 102. That is, the pad 102 has a square shape, the opening portion 114 is formed in the protection film 115 on the pad 102. The two corner portions of this opening portion 114 facing one side of a chip 100 which a wire (not shown) crosses are cut to have obtuse angels.

As described above, when the shape of the opening portion 114 formed in the protection film 115 on the pad 102 is changed, the same effect as described in the above embodiments can be obtained. Even when the opening portion 114 has the above shape, since a contact area between the pad and the wire is not substantially changed, contact strength between the pad and the wire is not decreased.

The present invention is not limited to the above embodiments, and various changes and modifications may effected without departing from the spirit and scope of the present invention.

## Claims

1. A semiconductor device employing a wire bonding method for wiring a bonding pad formed on a semiconductor chip to an inner lead portion of a lead frame with a bonding wire, characterized in that:
   a planar shape of said bonding pad (102) has at least one obtuse-angle corner portion facing a nearest side of said semiconductor chip (100).

2. A semiconductor device employing a wire bonding method for wiring a bonding pad formed on a semiconductor chip to an inner lead portion of a lead frame with a bonding wire, characterized in that:
   a planar shape of a bonding pad (102) formed near a corner portion of said semiconductor chip (100) has at least one obtuse-angle corner portion facing a nearest side of said semiconductor chip (100).

3. A device according to any one of claims 1 and 2, characterized in that said bonding pad (102) is formed in a region running along an outer periphery of said semiconductor chip (100).

4. A device according to any one of claims 1 and 2, characterized in that a planar shape of said bonding pad (102) is a pentagon.

5. A device according to any one of claims 1 and 2, characterized in that a planar shape of said bonding pad (102) is a hexagon.

6. A semiconductor device employing a wire bonding method for wiring a bonding pad formed on a semiconductor chip to an inner lead portion of a lead frame with a bonding wire, characterized by comprising: a first-level bonding pad (110) formed on said semiconductor chip (100); an insulating film (112) formed on said first-level bonding pad (110) and said semiconductor chip (100); an opening portion (103) formed in said insulating film (112) on said first-level bonding pad (110); and a second-level bonding pad (102) formed on said insulating film (112) and said first-level bonding pad (110) formed in said opening portion (103), said second-level bonding pad being formed such that a planar shape of said second-level bonding pad (102) has at least one obtuse-angle corner portion facing a nearest side of said semiconductor chip;

wherein said second-level bonding pad (102) is electrically connected to an inner lead portion (106) of a lead frame by the bonding wire (104).

7. A device according to claim 6, characterized in that said first-level bonding pad (110) and said second-level bonding pad (102) are formed in a region running along an outer periphery of said semiconductor chip.

8. A device according to claim 6, characterized in that a planar shape of said first-level bonding pad (102) is a pentagon.

9. A device according to claim 6, characterized in that a planar shape of said second-level bonding pad (102) is a hexagon.

10. A semiconductor device employing a wire bonding method for wiring a bonding pad formed on a semiconductor chip to an inner lead portion of a lead frame with a bonding wire, characterized by comprising: a protection film (115) formed on said semiconductor chip (100) and said bonding pad (102); and an opening portion (114) formed in said protection film (115) on said bonding pad (102) such that at least one of corner portions facing a nearest side of said semiconductor chip (100) is an obtuse-angle portion;

wherein said bonding pad (102) is electrically connected to an inner lead portion (106) of a lead frame through said opening portion (104).

11. A device according to claim 10, characterized in that said bonding pad (102) is formed in a region along an outer periphery of said semiconductor chip (100).

12. A device according to claim 10, characterized in that a shape of said opening portion (114) is a pentagon.

13. A device according to claim 10, characterized in that a shape of said opening portion (114) is a hexagon.

F I G. 1

F I G. 2

102-1 102-2

104

100

101

106

F I G.  3

F I G. 4

F I G. 5

102 110

110

102

112

102 103

110

DIRECTION
CHIP CENTER

100

# F I G. 6

114    110    110    115    114    114    102

DIRECTION
CHIP CENTER

100

F I G. 7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | DE-A-3 916 636 (UNITED TECHNOLOGIES CORP.) * claim 1; figures 1,3 * | 1-4 | H01L23/485 |
| X | DE-A-2 942 394 (HITACHI LTD.) * claims 1,2; figure 4 * | 1-3 | |
| A | IBM TECHNICAL DISCLOSURE BULLETIN. vol. 21, no. 4, September 1978, NEW YORK US pages 1461 - 1462; E. BERNDLMAIER: 'Chip orientation aid.' | 1,2,5 | |
| A | PATENT ABSTRACTS OF JAPAN vol. 6, no. 119 (E-116)(997) 3 July 1982 & JP-A-57 045 938 ( HITACHI ) 16 March 1982 * abstract * | 10,11 | |
| A | PATENT ABSTRACTS OF JAPAN vol. 9, no. 118 (E-316)(1841) 23 May 1985 & JP-A-60 007 757 ( NIPPON DENKI K.K. ) 16 January 1985 * abstract * | 10,11 | |
| | | | TECHNICAL FIELDS SEARCHED (Int. Cl.5) |
| A | FR-A-2 616 964 (THOMSON) | | H01L |
| A | PATENT ABSTRACTS OF JAPAN vol. 10, no. 65 (E-388)(2122) 14 March 1986 & JP-A-60 217 652 ( HITACHI ) 31 October 1985 * abstract * | | |

The present search report has been drawn up for all claims

| Place of search | Date of completion of the search | Examiner |
|---|---|---|
| THE HAGUE | 10 MARCH 1992 | DE RAEVE R.A.L. |